Europäisches Patentamt

(19) European Patent Office

Office européen des brevets

(11) Numéro de publication: **0 335 783**
A1

## (12) DEMANDE DE BREVET EUROPEEN

(21) Numéro de dépôt: 89400835.8

(22) Date de dépôt: 24.03.89

(51) Int. Cl.4: **H 01 L 23/52**
H 05 K 7/20

(30) Priorité: 30.03.88 FR 8804199

(43) Date de publication de la demande:
04.10.89 Bulletin 89/40

(84) Etats contractants désignés: DE ES GB IT SE

(71) Demandeur: **Siemens Aktiengesellschaft**
**Wittelsbacherplatz 2**
**D-8000 München 2 (DE)**

(72) Inventeur: **Boucard, Joseph René Michel**
**26 rue du Rhône**
**F-31170 Tournefeuille (FR)**

**Thirion, Christian, François**
**33 Avenue Justin Pagès**
**F-31190 Auterive (FR)**

(74) Mandataire: **Colas, Jean-Pierre et al**
**Cabinet de Boisse 37, avenue Franklin D. Roosevelt**
**F-75008 Paris (FR)**

(54) Boîtier pour circuit électronique.

(57) Le boîtier comprend un fond 1 dans l'épaisseur duquel est noyée l'extension d'une broche 5 d'entrée/sortie du boîtier. Cette extension se termine par un plot de contact 15 qui affleure à la surface d'un substrat 7 portant des composants électroniques passifs ou actifs 11, 12 et des pistes conductrices d'interconnexion 10, 10', 10''. Une piste conductrice 10 passant sur une découpe 6 du substrat qui loge le plot 15 est soudée sur ce plot pour interconnecter une borne 14 du composant 12 avec la broche 5 d'entrée/sortie du boîtier. On s'affranchit ainsi d'une interconnexion par plots latéraux 13, 13', 13'',... qui complique la topographie des pistes conductrices à prévoir à cet effet.

Application à un boîtier pour circuit utilisé en électronique automobile.

FIG.:1

## Description

## Boîtier pour circuit électronique

La présente invention est relative à un boîtier pour circuit électronique et, plus particulièrement, à un tel boîtier conçu pour abriter un circuit électronique à liaisons automatisables.

Un circuit électronique constitué de plusieurs composants actifs ou passifs disposés sur un substrat est couramment disposés dans un boîtier qui le protège des agressions extérieures. Il faut alors assurer des liaisons électriques entre le circuit placé dans le boîtier et un environnement électrique et/ou électronique extérieur à ce boîtier pour assurer la circulation des divers signaux d'entrée ou de sortie nécessaires au fonctionnement du boîtier dans cet environnement. A titre d'exemple d'une telle situation on peut citer le cas d'un boîtier de circuit électronique assurant, par l'élaboration de signaux convenables, la commande de divers actuateurs à partir de signaux reçus de divers capteurs. Une telle situation se rencontre couramment en électronique automobile.

Classiquement, les liaisons électriques nécessaires sont établies par l'intermédiaire de broches qui traversent la paroi du boîtier et qui sont agencées en lignes de manière à pouvoir coopérer avec un connecteur multiple, propre à relier chaque broche à une source d'un signal d'entrée du circuit ou à un composant ou appareil exploitant un signal élaboré par le circuit. A l'intérieur du boîtier, la liaison entre ces broches et le circuit est assurée par des fils ou des feuillards métalliques, soudés chacun à une extrémité sur une broche et, à l'autre extrémité, sur un plot métallique de contact formant partie d'une série de plots agencés en ligne parallèlement à l'un des bords du substrat qui porte le circuit électronique. On constate ainsi, pour chaque liaison, la présence de deux zones de soudure. On a songé à réduire le nombre de ces soudures pour augmenter la fiabilité du circuit et réduire son coût de fabrication. Pour ce faire, on a proposé que le boîtier soit équipé d'une broche qui se prolonge, à l'intérieur du boîtier, d'une patte souple formée d'une pièce avec la broche, la seule extrémité libre de cette patte étant alors soudée sur un plot de contact placé près d'un bord du substrat du circuit.

Outre les inconvénients mentionnés des connexions par fils ou feuillards métalliques à deux zones d'extrémités soudées, on remarquera que tous les procédés de connexion décrits ci-dessus, qui font partie de la technique antérieure, présentent l'inconvénient d'exiger que les plots de connexion portés par le substrat soient alignés dans une zone proche d'au moins un bord du substrat, parallèle lui-même à une série de broches traversant le boîtier, ne serait-ce que pour diminuer la longueur des fils ou feuillards de liaison. Diverses pistes conductrices, portées par le substrat, connectent les plots du substrat au circuit électronique proprement dit. Il est clair que ces pistes doivent s'éviter mutuellement, ce qui présente l'inconvénient de compliquer la topographie des pistes portées par le substrat.

La présente invention a pour but de réaliser un boîtier pour circuit électronique, conçu pour simplifier l'établissement de liaisons électriques entre ce circuit et des broches d'entrée/sortie du boîtier, et qui n'exige pas que ces liaisons soient établies par l'intermédiaire de plots de contact spécialisés agencés au voisinage d'au moins un des bords d'un substrat portant le circuit électronique.

La présente invention a aussi pour but de réaliser un tel boîtier dans lequel lesdites liaisons électriques mettent en jeu des pistes conductrices normalement disposées sur le substrat du circuit.

La présente invention a encore pour but de réaliser un tel boîtier conçu pour n'imposer aucune contrainte topographique quant à la localisation des liaisons électriques entre le circuit et les broches d'entrée/sortie du boîtier, pour assurer ainsi une grande souplesse d'implantation de ces liaisons.

La présente invention vise en outre un boîtier pour circuit électronique qui se prête à l'automatisation de l'établissement desdites liaisons électriques, lors de la fabrication en série d'un tel boîtier.

On atteint ces buts de l'invention, ainsi que d'autres qui apparaîtront dans la suite de la présente description, avec un boîtier pour circuit électronique comportant un fond sur lequel est fixé un substrat en matière isolante dont au moins une face porte des composants actifs et/ou passifs et des pistes ou plages conductrices de l'électricité connectant les composants entre eux et/ou à des broches de contact électriques débordant extérieurement du boîtier pour assurer l'interconnexion du circuit contenu dans le boîtier avec au moins un appareil électrique et/ou électronique associé et extérieur au boîtier, caractérisé en ce qu'au moins une des broches se prolonge dans l'épaisseur de la paroi du boîtier pour traverser la face du fond de celui-ci qui porte le substrat et passer dans une découpe formée dans ce dernier pour présenter une extrémité en affleurement sur la face du substrat qui porte les pistes ou plages conductrices, au moins une de ces pistes ou plages passant au-dessus de cette découpe de manière à être en contact électrique avec cette extrémité de la broche.

Ainsi, grâce au boîtier selon l'invention, on évite d'avoir à contourner, sur le substrat, des pistes conductrices qui pourraient gêner la connexion d'une piste particulière à une broche d'entrée ou de sortie, par l'intermédiaire d'un plot de connexion formé à proximité d'un bord du substrat. Il est possible alors de désencombrer ce substrat des pistes utilisées classiquement pour connecter le circuit aux broches.

Le boîtier suivant l'invention procure encore une grande souplesse dans le choix des points de connexion entre les broches et le circuit car ceux-ci peuvent être localisés en tous points du substrat ce qui concourre à l'optimisation de la topographie du circuit porté par le substrat, par la liberté supplémentaire qui est ainsi offerte au concepteur du circuit.

Au dessin annexé, donné seulement à titre d'exemple :

La figure 1 est une vue partielle en perspective et en coupe d'un boîtier pour circuit électronique suivant la présente invention,

la figure 2 est une vue en coupe d'une partie d'un boîtier suivant un deuxième mode de réalisation de l'invention,

la figure 3 est une vue en coupe d'une partie d'un boîtier suivant un troisième mode de réalisation de l'invention, et

la figure 4 est une vue en coupe d'une partie d'un boîtier suivant un quatrième mode de réalisation de l'invention.

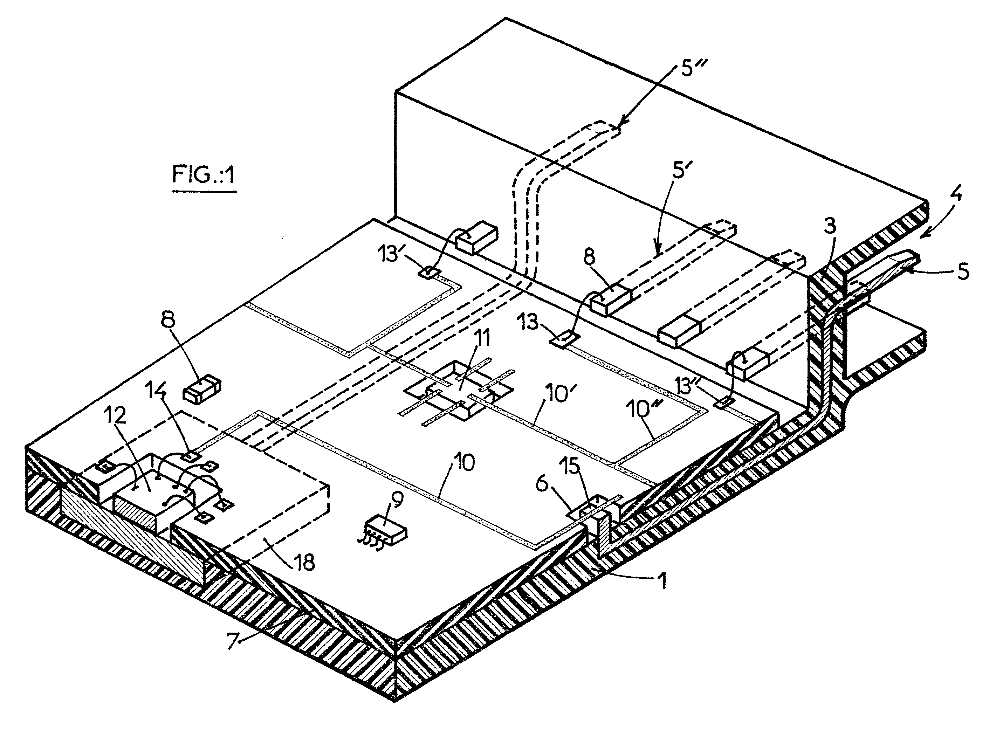

On se réfère tout d'abord à la figure 1 qui fait apparaître une partie du fond 1 du boîtier suivant l'invention, limitée par deux plans de coupe orthogonaux. Une même référence numérique, éventuellement indicée, repère aux figures des éléments ou organes identiques ou semblables.

Le boîtier est fermé hermétiquement par un couvercle (non représenté) fixé sur une ouverture supérieure du fond. D'une paroi latérale 3 du fond 1 déborde un logement 4 conçu pour protéger des groupes de broches de connexion électriques 5, 5' etc... agencées par exemple en deux lignes parallèles. Ce logement est dimensionné de manière à recevoir complémentairement un connecteur (non représenté) qui établit une liaison entre un circuit électronique contenu dans le boîtier et des organes ou appareils extérieurs qui échangent des signaux électriques avec le circuit que le boîtier a pour fonction de protéger de dégradations éventuelles résultant d'influences extérieures (humidité, température, poussière, etc...). Des trous sont percés dans une extension non représentée du fond du boîtier. Ces trous sont destinés à être traversés par des organes de fixation tels que des vis, pour la fixation du boîtier sur un support, en position d'utilisation. Toutes ces dispositions sont courantes et ne seront pas décrites plus avant.

Classiquement encore, un substrat 7 propre à recevoir des composants du circuit électronique est fixé sur le fond du boîtier. Ce substrat peut être réalisé en un matériau organique ou minéral et présenter une structure multi-couches avec couches conductrices ainsi qu'on le verra plus loin, et pistes conductrices telles que 10, 10', 10'' (voir figure 1), comme il est bien connu. Le substrat peut être constitué d'une feuille en polyimide, en résine époxy, en céramique, par exemple, d'épaisseurs comprises entre 0,1 et 1 mm, cette feuille portant des pistes conductrices.

Des composants passifs ou actifs de tous types sont montés sur le substrat conformément à l'organisation particulière du circuit, visant à lui faire exécuter telles ou telles fonctions. Les composants passifs peuvent être des résistances, condensateurs ou selfs classiques ou du type à montage en surface, par exemple. Les composants actifs peuvent être constitués par des composants discrets ou intégrés, sous forme de puce nue ou en boîtier de divers types connus. A titre d'exemple on a représenté sur le substrat du circuit contenu dans le boîtier de la figure 1, une résistance 8 à montage en surface et un circuit intégré 9 en boîtier pour montage en surface. Le circuit peut comprendre encore d'autres composants 11, 12. A titre d'exemple le composant 11 peut être un circuit intégré présentant plusieurs plots de sortie. Sur la figure 1 il apparaît que les pistes conductrices 10', 10'' connectent l'une de ces bornes de sortie à une broche 5' du boîtier selon l'invention, pour permettre au circuit intégré 11 d'échanger des signaux avec des appareils électriques ou électroniques extérieurs au boîtier, par l'intermédiaire de la broche 5'. Sur la figure 1 il apparaît que, du fait de la proximité du circuit intégré 11 par rapport au bord du substrat qui est parallèle à la paroi 3 du boîtier qui porte les broches d'entrée/sortie, il est possible de connecter simplement le circuit 11 à la broche 5' à l'aide de pistes conductrices courant sur la surface supérieure du substrat 7. Classiquement, cette liaison est complétée par un fil conducteur 8 soudé par ses extrémités d'une part à la broche 5' et d'autre part à un plot de contact 13. Sur le dessin il apparaît que ce plot de contact 13 fait partie d'un ensemble de plots 13, 13', 13'' etc... formés parallèlement au bord du substrat qui fait face à la paroi 3 du boîtier qui porte les broches, comme il est classique.

On se réfère maintenant au composant 12 représenté à la figure 1 comme occupant, par rapport à l'ensemble des plots 13, 13', 13'', une position plus éloignée que celle occupée par le circuit intégré 11. Le composant 12 est lui-même par exemple un circuit intégré nu comportant plusieurs plots de sortie dont l'un est connecté classiquement par un fil soudé à un plot de contact 14 formé sur le substrat. Du fait des positions intermédiaires occupées par les pistes conductrices 10' et 10'' sur le substrat, on comprend aisément à l'examen de la figure 1 qu'il est difficile, voire impossible, de connecter le plot 14 à la broche 5 par exemple, au moyen d'une piste conductrice courant sur le substrat 7. Pour résoudre cette difficulté, la solution classique consiste à compliquer la configuration des pistes 10' et 10'' de manière à dégager un passage vers un plot de contact de la série 13, 13', 13'' etc..., pour une piste conductrice dont l'origine se trouve au plot 14. De telles complications gênent le dessin des pistes conductrices qui doivent être formées sur le substrat 7.

Suivant la présente invention, on lève cette difficulté en prolongeant convenablement la broche 5 dans l'épaisseur de la paroi du boîtier de manière qu'une extrémité de cette broche puisse venir affleurer, par une découpe pratiquée dans le substrat, à la surface de ce substrat qui porte les pistes conductrices, dans une position où la connexion de cette broche au plot 14 par exemple peut être établie simplement par une piste conductrice 10 progressant dans un espace dégagé sur la surface du substrat jusqu'au plot de contact 14. Pour ce faire la broche 5 est profilée de manière à se conformer aux formes des parois du boîtier dans lesquelles elle doit passer pour atteindre une découpe 6 du substrat. Au niveau de cette découpe 6, la broche 5 est pliée de nouveau de manière que son extrémité prenne la forme d'un plot 15 affleurant à la surface du substrat 7. Ce plot 15 pourrait aussi être rapporté par rivetage ou soudure. Suivant l'invention la piste 10 passe au-dessus de la découpe 6 de manière à venir en contact avec le plot 15. Le contact électrique du plot 15 et de la piste 10 est assuré par une soudure convenable obtenue par des procédés classiques, soudure électrique, refusion de métal, thermocompression, etc... Bien entendu la piste conductrice 10 et le plot 15 de la broche 5 sont réalisés en des matériaux qui permettent la mise en oeuvre du procédé de soudure choisi.

On comprend que, grâce à la configuration particulière de la broche 5 incorporée au boîtier suivant l'invention, on peut faire sortir un plot de connexion tel que 15 de la plus grande partie de la surface du substrat, ce qui permet de ne pas être limité, pour les connexions aux broches du boîtier, aux plots 13, 13', 13" etc... alignés suivant un bord du substrat. Ainsi la projection géométrique de la broche sur la face du substrat qui porte des pistes conductrices peut-elle couper au moins une de ces pistes conductrices. La distribution des plots de contact 15 et des découpes 6 associées à ces plots, sur la surface du substrat peut être alors équilibrée et permettre l'occupation de plages de ce substrat qui seraient restées autrement inoccupées. On peut aussi dégager la surface du substrat de pistes conductrices telles que 10', 10" qui ne servent qu'à ramener sur un bord du substrat des connexions entre des bornes ou broches de composants électroniques et des broches d'entrée/sortie du boîtier.

Le substrat placé dans le boîtier suivant l'invention doit comporter des parties de pistes conductrices qui passent au-dessus de découpes telles que la découpe 6 du substrat. On peut obtenir de tels passages de pistes sur les découpes par la "méthode soustractive" classique utilisée pour réaliser des circuits imprimés. Suivant cette méthode on réalise tout d'abord dans le support du substrat les découpes pour le passage des plots, on lamine ensuite une couche de cuivre sur le substrat, avec ou sans colle. On utilisera de préférence pour la mise en oeuvre de l'invention une feuille de cuivre de 35 ou 70 micromètres d'épaisseur. La feuille de cuivre est alors recouverte d'un film photosensible sec et, du côté du substrat, l'autre face de la feuille de cuivre est doublée par laminage d'un film de renfort qui couvre au moins toute la surface de la découpe. Après exposition du film photosensible à la configuration de pistes souhaitée pour le substrat, et dépouillement de ce film, on obtient une partie de piste passant au-dessus de la découpe, d'un bord à l'autre de celle-ci. D'autres techniques connues pourraient être utilisées à cet effet. A titre d'exemple on peut citer le procédé d'interconnexion connu sous le nom de TAB (de l'expression anglo-saxonne "Tape Automated Bonding") dans sa version dite "TAB deux couches".

Bien entendu, les découpes des zones de liaison broche/circuit du substrat pourraient être entièrement obturées par une plage conductrice et non pas seulement partiellement couverte par une piste conductrice telle que celles dont il est question ci-dessus.

Le boîtier suivant l'invention peut être réalisé de préférence par la technique du moulage par injection. Plus précisément, on fixe alors les broches telles que la broche 5 contre le fond d'un moule à l'aide de plots de maintien, dans des positions prédéterminées correspondant à celles assignées au plot 15 sur le fond du boîtier à obtenir, et on utilise ensuite la technique du double moulage pour fixer les broches en position et remplir ensuite les emplacements occupés par les plots de maintien, après retrait de ceux-ci.

Divers matériaux thermoplastiques ou thermodurcissables peuvent être utilisés pour les injections, au choix de l'homme de métier. On pourra par exemple choisir les produits vendus sous les dénominations RYTON, VALOX 420, RINITE 530, commercialisés par les sociétés dites PHILLIPS PETROLEUM, GENERAL ELECTRIC, DU PONT DE NEMOURS, respectivement.

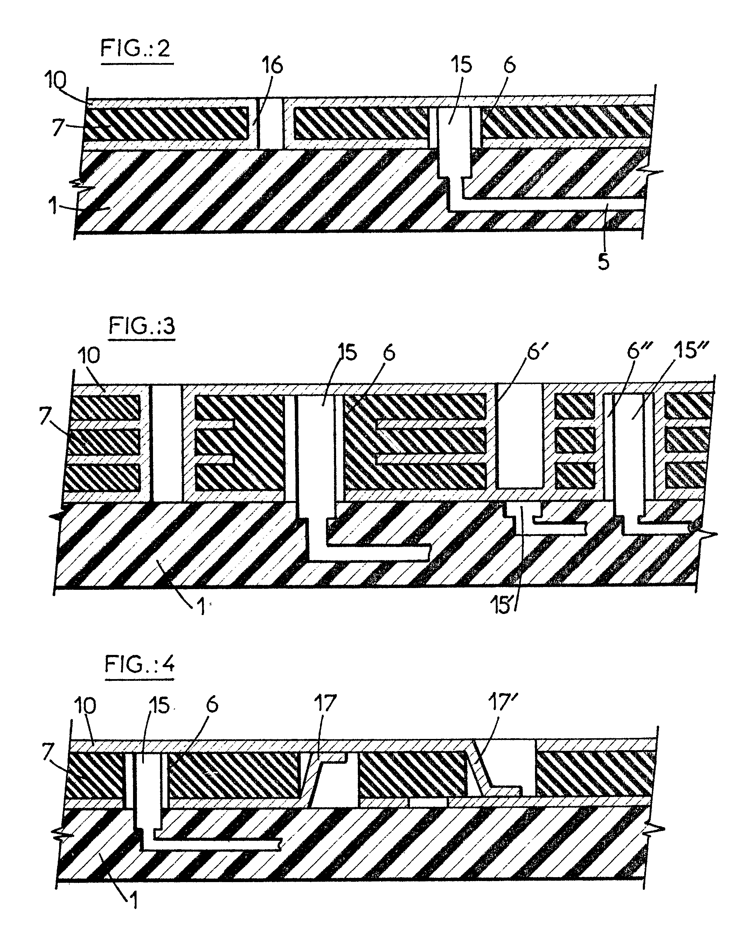

On se réfère maintenant aux figures 2 à 4 du dessin pour décrire différentes configurations particulières de substrat convenant à la mise en oeuvre de la présente invention. Ces figures représentent des coupes de ces substrats passant par un plot de contact 15 suivant l'axe d'une piste conductrice soudée à ce plot. A ces figures des références numériques identiques ou indicées correspondent à des éléments ou organes identiques ou similaires.

A la figure 2, le substrat en matériau isolant 7 est métallisé sur ses deux faces suivant des configurations de pistes ou de plages conductrices, les métallisations étant interconnectées par des trous métallisés tels que le trou 16 traversant le substrat. Dans ce mode de réalisation, le plot 15 de la broche 5 est soudé à une piste conductrice formée sur la face supérieure (du point de vue de la figure) du substrat. Au droit de la découpe 6, la face inférieure du substrat est libre de toute métallisation. Bien entendu, on pourrait aussi établir un contact électrique au niveau de la face inférieure métallisée du substrat.

La figure 3 représente un substrat multi-couches comprenant plusieurs couches conductrices distribuées dans l'épaisseur du substrat 7, les deux faces externes du substrat 7 étant elles-mêmes métallisées suivant des configurations de pistes ou de plages conductrices. Avec ce type de substrat, le contact électrique entre un plot 15 et une piste conductrice peut s'établir dans une découpe 6 par exemple, au niveau de la face supérieure du substrat, ou, au contraire, au niveau de la face inférieure de ce substrat, par l'intermédiaire d'un plot 15' noyé dans le fond 1 du boîtier et affleurant à la surface de ce fond, en contact électrique avec une plage ou piste conductrice formée sur la face du substrat qui est en regard de ce fond. La découpe 6' prend alors la forme d'un trou entièrement métallisé. Alternativement le contact entre un plot 15' et une piste conductrice courant sur la face supérieure du substrat 7 peut être établi dans une découpe 6" entièrement métallisée à partir de la face du substrat qui est en regard du fond du boîtier.

A la figure 4, le substrat représenté prend la forme de celui utilisé dans le procédé d'interconnexion dit "TAB deux couches" mentionné ci-dessus. Suivant ce procédé d'interconnexion, les couches ou pistes conductrices formées sur les deux faces du substrat 7 sont interconnectées par des pattes 17, 17' traversant le substrat à l'intérieur de découpes formées à cet effet dans le substrat. Un tel type de substrat s'accomode parfaitement de l'incorporation des plots de contact 15 des broches 5 suivant l'invention, passant dans des découpes 6 dudit substrat.

On revient à la figure 1 où l'on a représenté en traits interrompus une broche 5" qui se prolonge elle aussi dans l'épaisseur des parois du fond du boîtier suivant l'invention par un radiateur 18 dont une face affleure sur le fond du boîtier. Dans l'exemple de réalisation réprésenté à la figure 1, le composant 12 est un composant de puissance présentant une électrode étendue, soudée sur le radiateur 18 qui dissipe des calories engendrées au niveau de cette électrode par le passage d'un courant fort, pour éviter tout échauffement du circuit. A cet effet, le composant de puissance 12 est lui-même placé dans une découpe appropriée du substrat. Un boîtier comprenant un tel radiateur est décrit plus complètement à la demande de brevet français No. 87 12241 déposée le 3 septembre 1987 par la demanderesse. On remarquera que les broches 5 à plots d'interconnexion 15 du boîtier suivant l'invention peuvent être associées à une broche 5" à radiateur 18 noyée dans le fond du boîtier par surmoulage commun dans la matière constituant le boîtier. On peut associer ainsi des fonctions d'interconnexion d'une part et de refroidissement d'autre part dans un boîtier unique incorporant des broches noyées dans la matière du boîtier.

Bien entendu l'invention n'est pas limitée aux modes de réalisation décrits et représentés qui n'ont été donnés qu'à titre d'exemple. En particulier des configurations de broches variées pourraient être adoptées notamment dans la partie de ces broches qui passent dans le fond 1 du boîtier. Il faut alors assurer une imbrication convenable des emplacements suivis par les diverses broches dans ce fond.

De même un plot de connexion tel que 15 peut être défini en un emplacement tel que celui occupé par le plot de raccordement 14 de la piste conductrice 10, pour assurer ainsi un raccordement direct du plot 15 à la borne correspondante du composant 12, par l'intermédiaire d'un fil soudé classique, par exemple.

Le boîtier suivant l'invention permet de doubler la surface offerte aux interconnexions entre le circuit porté par le substrat et les broches d'entrée/sortie du boîtier. Le plan d'interconnexion classique constitué par une surface du substrat est en effet doublé par le plan situé dans l'épaisseur du boîtier, où passent les prolongations des broches vers les plots 15 d'interconnexion.

Ce doublement évite les problèmes de contournement d'autres pistes à la surface du substrat, lorsqu'on cherche à rejoindre classiquement des plots de connexion formés près d'un bord du substrat. Il y a aussi diminution de la longueur des pistes conductrices d'interconnexion et désencombrement de la surface du substrat. En outre, grâce au boîtier suivant l'invention, il est possible d'interconnecter simplement un point quelconque du circuit porté par le substrat et une broche d'entrée/sortie du boîtier. Il est clair aussi que le boîtier suivant l'invention se prête à des fabrications en grandes séries, comme celles que l'on rencontre en électronique automobile par exemple, grâce au caractère "automatisable" de l'établissement des liaisons électriques nécessaires entre les broches d'entrée/sortie du boîtier et le circuit contenu dans ce boîtier, par des opérations de soudure mécanisées.

**Revendications**

1. Boîtier pour circuit électronique, comportant un fond sur lequel est fixé un substrat en matériau isolant dont au moins une face porte des composants actifs et/ou passifs et des pistes ou plages conductrices de l'électricité connectant les composants entre eux, et/ou des broches de contact électriques débordant extérieurement du boîtier pour assurer l'interconnexion du circuit contenu dans le boîtier avec au moins un appareil électrique et/ou électronique associé et extérieur au boîtier, caractérisé en ce qu'au moins une (5) des broches se prolonge dans l'épaisseur de la paroi du fond (1) du boîtier pour traverser la face du fond de celui-ci qui porte le substrat et passer dans une découpe (6) formée dans ce dernier pour présenter une extrémité en forme de plot de contact (15) qui affleure sur la face du substrat portant les pistes ou plages conductrices, au moins une (10) de ces pistes ou plages passant au-dessus de cette découpe de manière à être en contact électrique avec ce plot de contact de la broche.

2. Boîtier conforme à la revendication 1, caractérisé en ce que la projection géométrique de la broche sur la face du substrat qui porte des pistes ou plages conductrices coupe au moins une de ces pistes ou plages conductrices.

3. Boîtier conforme à l'une quelconque des revendications 1 et 2, caractérisé en ce qu'il comprend plusieurs broches dont les extrémités extérieurs au boîtier sont alignées alors que les plots de contact de ces broches qui affleurent sur la surface du substrat portant des pistes conductrices sont dispersés sur cette surface.

4. Boîtier conforme à l'une quelconque des revendications 1 à 3, caractérisé en ce que le substrat en matériau isolant est métallisé sur ses deux faces suivant des configurations de pistes ou plages conductrices, le plot de contact affleurant d'une broche traversant à la fois la face métallisée du substrat qui est en contact avec le fond du boîtier et l'épaisseur du substrat, pour venir en contact électrique avec au moins une piste ou plage de l'autre face du substrat.

5. Boîtier conforme à l'une quelconque des revendications 1 à 3, caractérisé en ce que le substrat comprend plusieurs couches métalliques écartées les unes des autres dans son épaisseur, le plot de contact d'une broche venant en contact électrique avec l'une des couches externes et la liaison électrique entre ces couches étant assurée par des trous métallisés formés dans ces couches et dans le substrat.

6. Boîtier conforme à l'une quelconque des revendications 1 à 3, caractérisé en ce que le substrat est recouvert sur ses deux faces par des couches métalliques interconnectées par des pattes suivant le procédé d'interconnexion dit "TAB deux couches".

7. Boîtier conforme à l'une quelconque des revendications 1 à 6, caractérisé en ce que la piste ou plage conductrice est soudée sur le plot de contact de la broche associée.

FIG.:1

FIG.: 2

FIG.: 3

FIG.: 4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | 35th Electronic Components Conference 20 mai 1985, Capital Hilton Hotel,Washington ,dc page 384 - 388; R:C LANDIS: "High-speed Packaging for GaAs interconnection" * page 385 * --- | 1 | H01L23/52 H05K7/20 |
| A | GB-A-2136203 (STANDARD TELEPHONES & CABLES PUBLIC LIMITED) * page 2, ligne 105 - ligne 125 * --- | 1, 4 | |
| A | FR-A-2603763 (REGIE NATIONALE DES USINES RENAULT) * page 2, ligne 20 - ligne 31 * ----- | 1, 6 | |

**DOMAINES TECHNIQUES RECHERCHES (Int. Cl.4)**

H05K
H01L

Le présent rapport a été établi pour toutes les revendications

| Lieu de la recherche | Date d'achèvement de la recherche | Examinateur |
|---|---|---|
| LA HAYE | 25 MAI 1989 | TOUSSAINT F.M.A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 

& : membre de la même famille, document correspondant

EPO FORM 1503 03.82 (P0402)